Europäisches Patentamt

(19) European Patent Office    (11) Publication number: **0 019 395**

Office européen des brevets    **B1**

(12)    **EUROPEAN PATENT SPECIFICATION**

(45) Date of publication of patent specification: **11.05.83**    (51) Int. Cl.³: **H 01 R 23/68, H 05 K 7/12**

(21) Application number: **80301426.5**

(22) Date of filing: **01.05.80**

(54) An electrical plug-receiving connector.

(30) Priority: **18.05.79 US 40242**

(43) Date of publication of application:
**26.11.80 Bulletin 80/24**

(45) Publication of the grant of the patent:
**11.05.83 Bulletin 83/19**

(84) Designated Contracting States:
**AT BE CH DE FR GB IT LI NL SE**

(56) References cited:
**EP - A - 0 009 867**
**AT - B - 339 988**
**DE - A - 2 925 590**

(73) Proprietor: **AMP INCORPORATED**
**Eisenhower Boulevard**
**Harrisburg Pennsylvania (US)**

(72) Inventor: **Hughes, Donald Wayne Kent**
**406 Sharon Avenue**
**Mechanicsburg, Pennsylvania 17055 (US)**

(74) Representative: **Terrell, Thomas Gwyn et al,**
**20 Queensmere**
**Slough Berkshire SL1 1YZ (GB)**

Courier Press, Leamington Spa, England.

An electrical plug receiving connector

There is disclosed in United States Patent Specification No. 3,850,497, an electrical plug receiving connector comprising an insulating housing having a plug receiving forward end and a rearward end, a plug-receiving opening extending into the plug-receiving end, such opening having opposed first and second internal side walls and opposed internal end walls, the housing having oppositely directed first and second external side walls and oppositely directed external end walls, a plurality of electrical contacts being assembled in juxtaposed spaced relationship and each comprising a contact spring portion extending from one of the internal side walls at a position adjacent to the plug receiving end, diagonally into the plug receiving opening and towards the opposite internal side wall, each contact having a lead portion extending from said position adjacent the plug receiving end towards the rearward end and externally of the housing, the plug receiving opening being dimensioned to receive a plug connector having spaced contact members therein to engage the contact spring portions of the contacts.

The lead portions of the contacts of this known receptacle connector are crimped to wires which are provided with electrical terminals for connection to external circuits.

For various applications, in particular in computer equipments, it is desirable that such connectors should be capable of being mounted on a circuit board to connect the contacts of the connector directly to the conductors of the circuit board, with one of the external end walls of the housing of the connector adjacent to the circuit board.

To this end, an electrical connector as defined in the first paragraph of this specification is, according to the invention, characterised in that the lead portions of the contacts extend from said position adjacent the plug receiving end partially across said first external side wall which is adjacent to the first internal side wall, and are cranked laterally at locations between the ends of the housing so as to extend towards, and so as to project beyond, one of the external end walls, for connection to conductors of a circuit board.

For a better understanding of the present invention reference will now be made by way of example to the accompanying drawings, in which:—

Figure 1 is an exploded perspective view of an electrical connector assembly;

Figure 2 is a view taken on the lines II—II of Figure 1, of an electrical receptacle connector of the assembly;

Figure 3 is a view taken on the lines III—III of Figure 2;

Figure 4 is a view taken on the lines IV—IV of Figure 3;

Figure 5 is a view taken on the lines V—V of Figure 3;

Figure 6 is a plan view of a portion of a strip of sheet metal blanks;

Figure 7 is a top perspective view of an electrical plug connector of the assembly of Figure 1; and

Figure 8 is an exploded perspective view showing the assembly of Figure 1 incorporated in a further assembly.

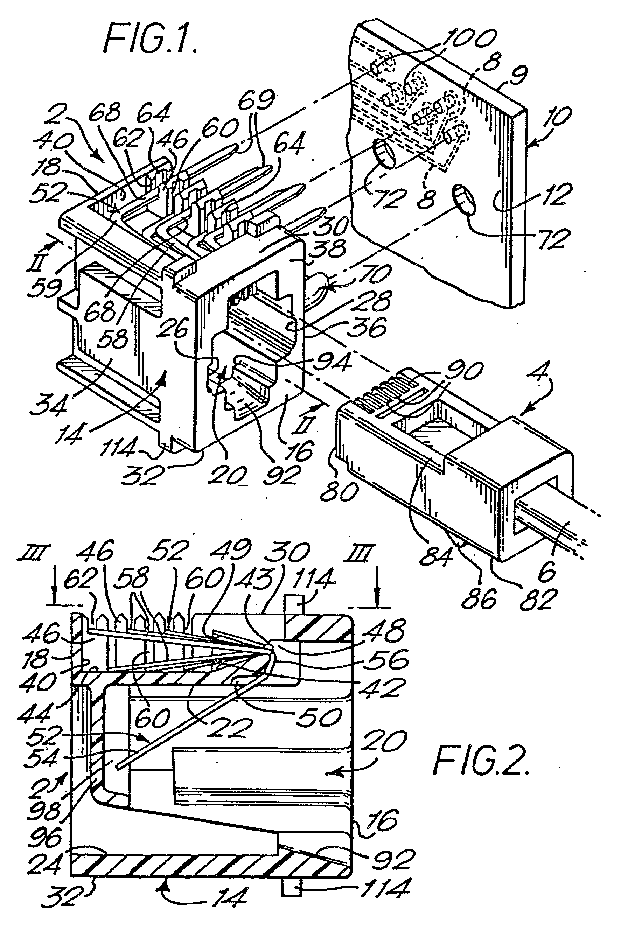

As shown in Figure 1, an electrical receptacle connector 2 serves to connect, by way of an electrical plug connector 4, the wires (not shown) of a multi-wire cable 6 to printed conductors 8 on the rear side 9 of a circuit board 10 only part of which is shown. The connector 2 is mounted on the front side 12 of the board 10, the conductors 8 being connected to metal linings in offset rows of holes 100 in the board 10, which holes receive end portions 69 of arms 68 of lead portions of contacts 52 of the connector 2.

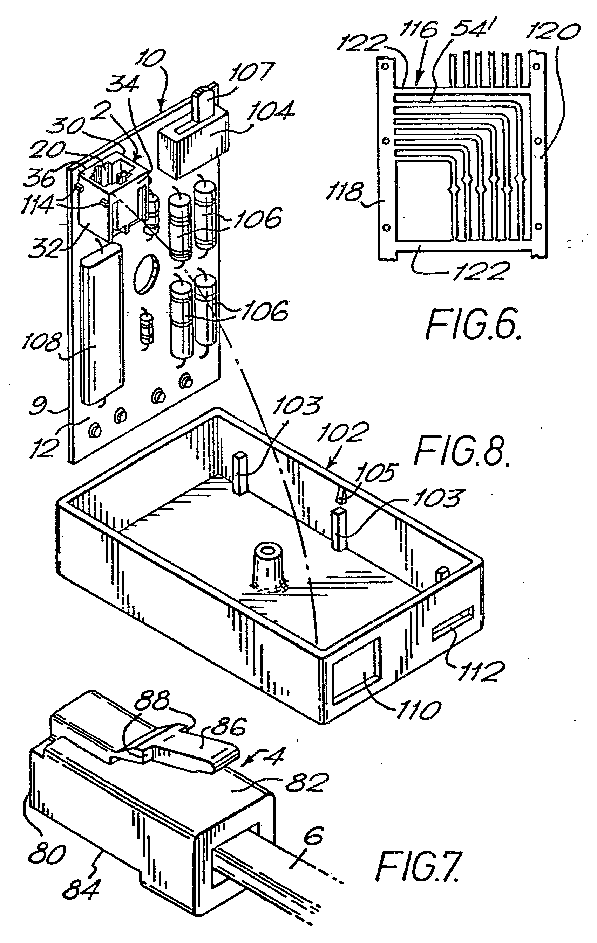

The connector 2 which comprises a moulded insulating housing 14 of plastics material, for example nylon, has a plug receiving forward end 16 and a rearward end 18, a plug receiving opening 20 extending inwardly into the housing 14 from the plug receiving end 16. As shown in Figure 5, the opening 20 has opposed internal side walls 22 and 24, and opposed internal end walls 26 and 28. The housing 14 has oppositely directed external side walls 30 and 32 which are proximate to the internal side walls 22 and 24 respectively, and oppositely directed external end walls 34 and 36 which are proximate to the opposed internal end walls 26 and 28, respectively.

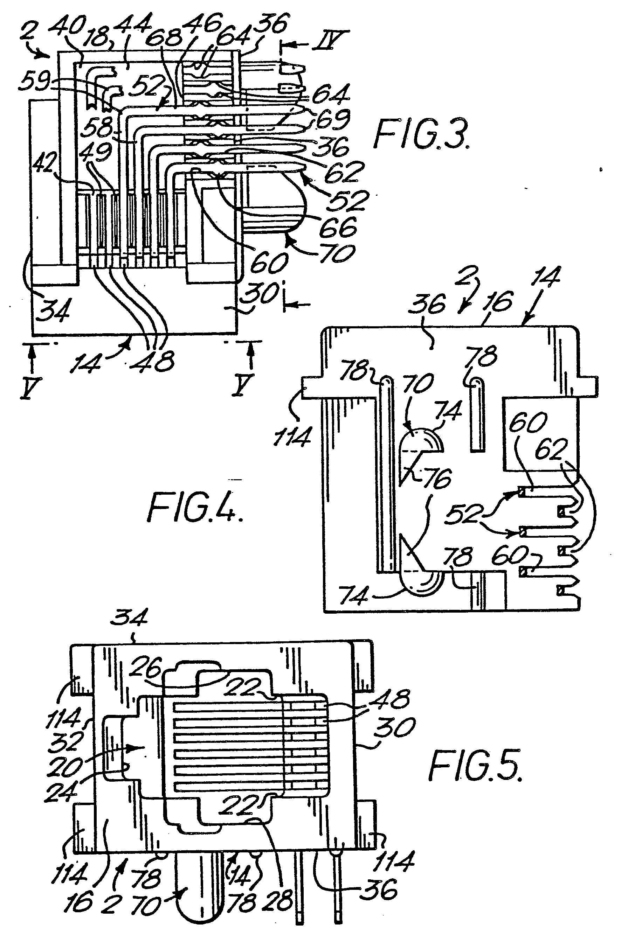

The opening 20 is surrounded, as shown in Figure 1, by a continuous frame 38 at the plug receiving end 16. The external side wall 30 which is proximate to the internal side wall 22 has a recess 40, Figures 1 to 3, therein. As best seen in Figure 2, the recess 40 extends from a position spaced from the plug receiving end 16, rearwardly of the housing 14 substantially up to the rearward end 18, one side 46 of the recess 40 extending parallel to, but being spaced from, the external end wall 36 as best seen in Figure 3. A portion 42 of the floor of the recess 40 is inclined from the forward end of the recess 40, to join a plane floor portion 44 of the recess 40, which portion 44 extends from the portion 42 to the rearward end of the recess 40.

A plurality, equal in number to that of the contacts 52, of apertures 48 are provided in the floor portion 42 of the recess 40. The apertures 48 are arranged in juxtaposed relationship in a row which extends between the external end walls 34 and 36. Each aperture 48 communicates with the plug receiving opening 20 and with the recess 40. The internal side wall 22 has a recess 50 adjacent to each aperture 48, beneath a curved surface 43 in such aperture 48, about which an intermediate portion 56 of one of the contacts 52 has been flexed so as to extend across the corresponding recess 50. Spaced barriers 49 are provided on the inclined portion 42 of the floor of the recess 40 between adjacent apertures 48 to separate arms 58 of cranked lead portions 58, 68 of the contacts 52 which arms 58 extend obliquely from the intermediate portions 56 into the recess 40.

The contacts 52 have contact spring portions 54 which extend from the intermediate portions 56 into the opening 20 diagonally towards the rearward end 18 of the housing 14, from the internal side wall 22 towards the internal side wall 24. The arms 58 of the lead portions 58, 68 of the contacts 52, which are connected to arms 68 thereof by bights 59, extend at right angles to the arms 68. The bights 59 are offset from each other diagonally across the recess 40 so that the contacts 52 are arranged in spaced, juxtaposed relationship, as seen in Figure 3, the arms 68 extending in such relationship towards and beyond the end wall 36. The external side wall 30 is provided with spaced alternate channels 60 and 62 which extend from the one side 46 of the recess 40 up to the end wall 36, the channels 60 being substantially deeper than the channels 62 as best seen in Figure 2. Alternate arms 58 are inclined from the apertures 48, away from the floor of the recess 40 the arms 68 connected thereto being lodged in the shallower channels 62, while the remaining arms 58 are inclined towards the floor of the recess 40, the arms 68 connected to these arms 58 being lodged in the deeper channels 60. The end portions 69 of the arms 68, which portions extend beyond end wall 36, are thus arranged in two offset rows for insertion into the holes of the offset rows of holes 100 in the board 10. The side walls of the channels 60 and 62 are provided with notches 64, as shown in Figures 1 and 3, which receive barbs 66 extending laterally from the side edges of the arms 68 of the contacts 52 thereby to maintain the arms 68 in the channels 60 and 62. The lead portions 58, 68 of the contacts 52, which portions extend from the apertures 48 to the channels 60 and 62 are held rigidly relative to the housing 14 by the engagement of the barbs 66 in the notches 64 and because the portions 56 of the contacts 52 are confined by the walls of the individual apertures 48.

Mounting feet 70 formed integrally with the end wall 36 of the housing 14 are dimensioned to be received in spaced holes 72 in the circuit board 10. The feet 70, which may be described in the specification of our European Patent Application No. 80300751.7, Publication No. EP—A—17358, each comprise, as best seen in Figure 4, a semi-circular cross-sectional portion 74 from which a fin 76 extends, the fin 74 being tapered towards the outer free end of the foot 70 so that the fin is collapsed as the foot 70 enters a hole 72. Standoff ribs 78 are provided on the external end wall 36 to space it from the surface 12 of the board 10 in order to avoid the flow of solder or flux to the connector 2, when the end portions 69 of the contacts 52 are being soldered to the conductors 8 on the board 10. The housing 14 has stop ears 114 extending from the walls 30 and 32. As shown in Figures 1 and 7, the plug connector 4 (which is of a kind which is described, for example, in United States Patent Specification No. 3,954,320) is substantially rectangular, having a leading end 80. A latch arm 86 extends from the upper (as seen in Figure 7) surface 82 of the connector 4, near the leading end 80 and has rearwardly facing shoulders 88 for engaging complementary shoulders 94 in the opening 20 of the connector 2. The wires of the cable 6 are connected, adjacent to the leading end 80, to contact members 90 (Figure 1) on the upper (as seen in Figure 1) surface 84 of the plug connector 4. The contact members 90 are adapted to engage the contact spring portions 54 of the contacts 52 when the connector 4 has been fully inserted into the opening 20 with its end 80 leading.

As best seen in Figure 2, an inclined ramp 92 on the internal side wall 24 of the plug receiving opening 20 is adapted to guide and depress the latch arm 86 as the plug connector 4 is inserted into the opening 20 so that the shoulders 88 of the arms 86 snap into engagement with the shoulders 94, which are positioned on each side of the ramp 92, when the plug has been fully inserted into the opening 20. The housing 14 also has a back wall 96 which extends downwardly (as seen Figure 2) from the internal side wall 22, spaced barriers extending forwardly from wall 96 to define stalls 98 which receive the free ends of the contact springs 54, for the avoidance of accidental short circuiting of the springs 54.

The individual contacts 52 are advantageously stamped and formed from frame-like blanks (Figure 6) comprising groups of conductors 116 for providing the contacts 52. A series of the blanks is produced in the form of a continuous strip provided with parallel spaced carrier strips 118 and 120 connecting the individual blanks, and transversely extending support strips 122 connecting the strips 118 and 120, a group of conductors 116 for a single housing 14 being contained between each pair of adjacent support strips 122. As shown in Figure 6, the ends of the contact spring forming portions 54' of the conductors 116 are formed integrally with the carrier strip 118, the opposite ends of the conductors 116 being formed integrally with one of the strips 122. The sheet spring metal e.g. brass, from which the blanks are stamped may be selectively plated with gold prior to stamping so that the portions 54' are provided with gold plating thereon. The conductors 116 which may be flat, or may be of arcuate cross-section as described in the specification of our European Patent Application No. 79301574.4, Publication No. EP—A—9867, are severed from the support strips 122 and from the carrier strips 118 when the conductors 116 are assembled to the housing 14, in accordance, for example, with the teaching of the European patent specification just mentioned.

As an alternative, the contacts 52 may be wire conductors (not shown) rather than stamped conductors, the apertures 48 and the channels 60 and 62 being dimensioned so that their walls grip such wire conductors. The contacts 52 are, however, preferably stamped, in the interests of ready assembly and improved electrical contact with the contact members 90 of the plug connector 4.

The receptacle connector 2 can be mounted on the circuit board 10 simply aligning the connector 2 with the circuit board openings 72 as shown in Figure 1, and moving the housing 14 against the surface of the board 10, so that the feet 70 enter the holes 72 and the end portions 69 of the contacts 52 enter the holes 100. The feet 70 will hold the housing 14 to the board 10 to allow the end portions 69 of the contacts 52 to be soldered to the conductors 8 of the board 10 by passing it through a wave soldering apparatus (not shown).

The connector 2 is of particular use for boards 10 which are to be mounted vertically in spaced, juxtaposed relationship. Since the distance between the walls 34 and 36 is the smaller of the two lateral dimensions of the housing 14, the boards 10 can be more closely spaced from one another than would be the case if the rear wall 18 of the housing 14 were to be positioned against the board 10. The plug receiving opening 20 is oriented for convenient insertion of the plug connector 4, that is to say with the latch arm 86 facing up or down, depending upon which side of the board 10 the connector 2 is mounted on.

Figure 8 shows an assembly comprising the connector 2 mounted on the circuit board 10 which is contained in a rectangular, box-like insulating casing 102 having an open side. The casing 102 may be provided with a cover (not shown) for its open side, or it may be mounted with its open side against a panel (not shown). The assembly also comprises a switch 104 having a switch arm 107, and circuit elements 106 and 108 on the board 10. The wires of the cable 6 (not shown in Figure 8) are connected to the circuit board conductors on the side 9 of the board 10, through the plug connector 4 (not shown in Figure 8) and the connector 2. When the circuit board 10 is positioned in the casing 102 to rest on posts 103 therein and being held in position by latches 105 (only one of which is shown), the switch arm 107 projects through a first windown 112 in an end wall of the casing 102, the plug receiving opening 20 of the connector 2 being in alignment with a second window 110 in the same end wall of the casing 102. It will be apparent that the depth of the casing 102 is determined by the distance between the walls 34 and 36 of the housing 14, which as mentioned above is smaller than that between the walls 30 and 32 of the housing 14. Such an assembly is for particular use in computer equipments.

**Claims**

1. An electrical plug receiving connector (2) comprising an insulating housing (14) having a plug receiving forward end (16) and a rearward end (18), a plug receiving opening (20) extending into the plug receiving end (16), such opening (20) having opposed first and second internal side walls (22 and 24) and opposed internal end walls (26 and 28), the housing (14) having oppositely directed first and second external side walls (30 and 32) and oppositely directed external end walls (34 and 36), a plurality of electrical contacts (52) being assembled in juxtaposed spaced relationship and each comprising a contact spring portion (54) extending from one (22) of the internal side walls (22 and 24) at a position adjacent to the plug receiving end (16), diagonally into the plug receiving opening (20) and towards the opposite internal side wall (24), each contact (52) having a lead portion (58, 68) extending from said position adjacent the plug receiving end (16) towards the rearward end (18) and externally of the housing (14), the plug receiving opening (20) being dimensioned to receive a plug connector (4) having spaced contact members (90) therein to engage the contact spring portions (54) of the contacts (52); characterised in that the lead portions (58, 68) of the contacts (52) extend from said position adjacent the plug receiving end (16) partially across said first external side wall (30) which is adjacent to the first internal side wall (22), and are cranked laterally at locations (59) between the ends (16 and 18) of the housing (14) so as to extend towards, and so as to project beyond, one (36) of the external end walls (34 and 36), for connection to conductors (8) of a circuit board (10).

2. An electrical connector according to claim 1, characterised in that each of a plurality of juxtaposed channels (60 and 62) in the first external side wall (30) receives the lead portion (58, 68) of one of the contacts (52).

3. An electrical connector according to claim 2, characterised in that alternate ones (60) of the channels (60 and 62) are deeper than the remaining channels (62) whereby those portions (69) of the contacts (52) which portions project beyond the one external side wall (36) are arranged in two offset rows.

4. An electrical connector according to claim 2 or 3, characterised in that the lead portions (58, 68) of the contacts (52) are received in a recess (40) in the adjacent external side wall (30), the channels (60 and 62) communicating with the recess (40).

5. An electrical connector according to any one of the preceding claims, characterised in that apertures (48) receiving intermediate portions (56) of the contacts (52), extend through the adjacent external side wall (30) to the plug receiving opening (20), the apertures (48) being arranged in a row extending between the end walls (34 or 36) and adjacent to the plug receiving end (16), the adjacent external side wall (30) having a plurality of contact separating barrier walls (49) thereon, which extend from positions adjacent to the apertures (48), between adjacent apertures (48) and towards the rearward end (18) of the housing (14).

6. An electrical connector according to claim 2, 3 or 4, characterised in that each contact (52) has been stamped and formed from a strip of sheet metal, the lead portion (58, 68) comprising two arms (58 and 68) extending at right angles to one another, one arm (68) which projects beyond the one external end wall (36) and which is received in one of the channels (60 or 62) having laterally projecting barbs (66) received in notches (64) in the walls of the channel (60 or 62).

7. An electrical connector according to any one of the preceding claims, characterised in that the one external side wall (36) is provided with a foot (70) for reception in a hole (72) in the circuit board (10) to secure the housing (14) to the circuit board (10) and with stand off means (78) serving to space the external side wall (36) from the circuit board (10) when the housing (14) has been secured thereto. —

**Patentansprüche**

1. Elektrischer Steckerbuchsen-Verbinder (2) mit einem isolierenden Gehäuse (14), welches ein vorderes Steckeraufnahmeende (16) und ein hinteres Ende (18) aufweist, wobei sich eine Steckeraufnahmeöffnung (20) in das Steckeraufnahmeende (16) hineinerstreckt und diese Öffnung (20) gegenüberliegende erste und zweite innere Seitenwände (22 und 24) und gegenüberliegende innere Endwände (26 und 28) aufweist, wobei ferner das Gehäuse (14) entgegengesetzt ausgerichtete erste und zweite äußere Seitenwände (30 und 32) und entgegengesetzt ausgerichtete äußere Endwände (34 und 36) aufweist, eine Vielzahl von elektrischen Kontakten (52) in nebeneinanderliegend beabstandeter Beziehung eingebaut ist, von denen jeder einen Kontaktfederabschnitt (54) aufweist, der sich von einer (22) der inneren Seitenwände (22 und 24) an einer Position in der Nähe des Steckeraufnahmeendes (16) diagonal in die Steckeraufnahmeöffnung (20) hinein und zur gegenüberliegenden inneren Seitenwand (24) hinerstreckt, wobei ferner jeder Kontakt (52) einen Leitungsabschnitt (58, 68) aufweist, der sich von der Position in der Nähe des Steckeraufnahmeendes (16) zum hinteren Ende (18) und aus gem Gehäuse (14) herauserstreckt, und wobei die Steckeraufnahmeöffnung (20) zur Aufnahme eines Steckerverbinders (4) dimensioniert ist, in dem beabstandete Kontaktelemente (90) zum Eingriff mit dem Kontaktfederabschnitten (54) der Kontakte (52) vorgesehen sind, dadurch gekennzeichnet, daß die Leitungsabschnitte (58, 68) der Kontakte (52) sich von der Position in der Nähe des Steckeraufnahmeendes (16) teilweise über diejenige erste äußere Seitenwand (30) erstrecken, die der ersten inneren Seitenwand (22) benachbart ist, und seitlich an Stellen (59) zwischen den Enden (16 und 18) des Gehäuses (14) derart abgekröpft sind, daß sie sich zu einer (36) der äußeren Endwände (34 und 36) hinerstrecken und über diese zur Verbindung mit Leitern (8) einer Schaltungsplatte (10) hinausragen.

2. Elektrischer Verbinder nach Anspruch 1, dadurch gekennzeichnet, daß jeder einer Vielzahl von nebeneinanderligenden Kanälen (60 und 62) in der ersten äußeren Seitenwand (30) den Leitungsabschnitt (58, 68) eines der Kontakte (52) aufnimmt.

3. Elektrischer Verbinder nach Anspruch 2, dadurch gekennzeichnet, daß abwechselnde (60) der Kanäle (60 und 62) tiefer sind als die übrigen Kanäle (62), wodurch diejenigen Teile (69) der Kontakte (52), die über die eine äußere Seitenwand (36) hinausragen, in zwei zueinander versetzten Reihen angeordnet sind.

4. Elektrischer Verbinder nach Anspruch 2 oder 3, dadurch gekennzeichnet, daß die Leitungsabschnitte (58, 68) der Kontakte (52) in einer Vertiefung (40) in der benachbarten äußeren Seitenwand (30) aufgenommen sind, wobei die Kanäle (60 und 62) mit der Vertiefung (40) in Verbindung stehen.

5. Elektrischer Verbinder nach einem der vorhergehenden Ansprüche, dadurch gekennzeichnet, daß Öffnungen (48), welche mittlere Teile (56) der Kontakte (52) aufnehmen, sich durch die benachbarte äußere Seitenwand (30) zu der Steckeraufnahmeöffnung (20) erstrecken, daß die Öffnungen (48) in einer sich zwischen den Endwänden (34 oder 36) erstreckenden Reihe und benachbart zum Steckeraufnahmeende (16) angeordnet sind, und daß die benachbarte äußere Seitenwand (30) eine Vielzahl von kontakttrennenden Trennwänden (90) aufweist, die sich von Stellen in der Nähe der Öffnungen (48) zwischen benachbarten Öffnungen (48) und zum hinteren Ende (18) des Gehäuses (14) hinerstrecken.

6. Elektrischer Verbinder nach Anspruch 2, 3 oder 4, dadurch gekennzeichnet, daß jeder Kontakt (52) aus einem Steifen Metallblech gestanzt und geformt ist, daß der Leitungsabschnitt (58, 68) zwei Arme (58 und 68) umfaßt, die sich in rechten Winkeln zueinander erstrecken, und daß ein Arm (68), der über die eine äußere Endwand (36) hinausragt und in einem der Kanäle (60 oder 62) aufgenommen ist, seitlich wegrangende Zacken (66) aufweist, die in Kerben (64) in den Wänden des Kanals (60 oder 62) aufgenommen sind.

7. Elektrischer Verbinder nach einem der vorhergehenden Ansprüche, dadurch gekennzeichnet, daß die eine äußere Seitenwand (36), mit einem Fuß (70) zur Aufnahme in einem Loch (72) in der Schaltungsplatte (10) versehen ist, um das Gehäuse (14) an der Schaltungsplatte (10) zu befestigen, und mit Abstandseinrichtungen (78), die zur Beabstandung der äußeren Seitenwand (36) von der Schaltungsplatte (10) dienen, wenn das Gehäuse (14) daran befestigt ist.

**Revendications**

1. Connecteur (2) recevant une fiche électrique, comprenant un boîtier isolant (14) ayant une extrémité avant (16) recevant une fiche et une extrémité arrière (18), une ouverture (20) de réception d'une fiche s'étendant dans l'extrémité (16) recevant une fiche, cette ouverture (20) comportant des première et seconde parois latérales intérieures opposées (22 et 24) et des parois extrêmes intérieures opposées (26 et 28), le boîtier (14) comportant des première et seconde parois latérales extérieures (30 et 32) de directions opposées et des parois extrêmes extérieures (34 et 36) de directions opposées, plusieurs contacts électriques (52) étant assemblés en juxtaposition et à distance les uns des autres et comprenant chacun une partie à ressort (54) de contact dépassant de l'une (22) des parois latérales intérieures (22 et 24), en une position adjacente à l'éxtrémité (16) recevant une fiche, diagonalement vers l'intérieur de l'ouverture (20) de réception d'une fiche et vers la paroi latérale intérieure opposée (24), chaque contact (52) ayant une partie conductrice (58, 68) s'étendant de ladite position adjacente à l'extrémité (16) recevant une fiche vers l'extrémité arrière (18) et extérieurement au boîtier (14), l'ouverture (20) de réception d'une fiche étant dimensionnée pour recevoir un connecteur à fiche (4) contenant des éléments de contact espacés (90) destinés à porter contre les parties à ressort de contact (54) des contacts (52); caractérisé en ce que les parties conductrices (58, 68) des contacts (52) s'étendent de ladite position adjacente à l'extrémité (16) recevant une fiche, partiellement en travers de ladite première paroi latérale extérieure (30) qui est adjacente à la première paroi latérale intérieure (22), et sont coudées latéralement en des positions (59) situées entre les extrémités (16 et 18) du boîtier (14), afin de s'étendre vers, et de dépasser ainsi de, l'une (36) des parois extrêmes extérieures (34 et 36), pour être connectées à des conducteurs (8) d'une carte à circuit (10).

2. Connecteur électrique selon la revendication 1, caractérisé en ce que chacune de plusieurs rainures juxtaposées (60 et 62) de la première paroi latérale extérieure (30) reçoit la partie conductrice (58, 68) de l'un des contacts (52).

3. Connecteur électrique selon la revendication 2, caractérisé en ce que certaines, alternées (60), des rainures (60 et 62) sont plus profondes que les rainures restantes (62), de manière que les tronçons (69) des contacts (52), lesquels tronçons dépassent de l'une (36) des parois latérales extérieures, sont disposés en deux rangées décalées.

4. Connecteur électrique selon la revendication 2 ou 3, caractérisé en ce que les parties conductrices (58, 68) des contacts (52) sont logées dans un évidement (40) situé dans la paroi latérale extérieure adjacente (30), les rainures (60 et 62) communiquant avec l'évidement (40).

5. Connecteur électrique selon l'une quelconque des revendications précédentes, caractérisé en ce que des ouvertures (48), recevant des parties intermédiaires (56) des contacts (52), s'étendent à travers la paroi latérale extérieure adjacente (30) jusqu'à l'ouverture (20) de réception d'une fiche, les ouvertures (48) étant disposées en une rangée s'étendant entre les parois extrêmes (34 ou 36) et adjacentes à l'extrémité (16) recevant une fiche, la paroi latérale extérieure adjacente (30) portant plusieurs cloisons (49) de séparation adjacentes aux ouvertures (48), entre des ouvertures adjacentes (48) et vers l'extrémité arrière (18) du boîtier (14).

6. Connecteur électrique selon la revendication 2, 3 ou 4, caractérisé en ce que chaque contact (52) a été embouti et formé à partir d'une bande de métal en feuille, la partie conductrice (58, 68) comprenant deux bras (58 et 68) s'étendant à angle droit l'un par rapport à l'autre, un bras (68), qui fait saillie au-delà de la première paroi extrême extérieure (36) et qui est reçue dans l'une des rainures (60 ou 62), comportant des ergots (66) dépassant latéralement et reçus dans des encoches (64) ménagées dans les parois de la rainure (60 ou 62).

7. Connecteur électrique selon l'une quelconque des revendications précédentes, caractérisé en ce que la première paroi latérale extérieure (36) comporte un pied (70) destiné à être reçu dans un trou (72) de la carte (10) à circuit pour fixer le boîtier (14) sur la carte (10) à circuit, et des moyens (78) d'espacement servant à écarter la paroi latérale extérieure (36) de la carte (10) à circuit lorsque le boîtier (14) a été fixé sur elle.

FIG.1.

FIG.2.

FIG.3.

FIG.4.

FIG.5.

FIG.6.

FIG.8.

FIG.7.